(19) **Europäisches Patentamt / European Patent Office / Office européen des brevets**

(11) **EP 4 621 422 A1**

(12) **EUROPEAN PATENT APPLICATION**
published in accordance with Art. 153(4) EPC

(43) Date of publication:
24.09.2025 Bulletin 2025/39

(51) International Patent Classification (IPC):
$G01R\ 31/00^{(2006.01)}$   $G01K\ 1/14^{(2021.01)}$
$G01K\ 7/24^{(2006.01)}$   $G01R\ 31/396^{(2019.01)}$
$H01M\ 10/48^{(2006.01)}$   $H02J\ 7/00^{(2006.01)}$

(21) Application number: 23891293.5

(52) Cooperative Patent Classification (CPC):
G01K 1/14; G01K 7/24; G01R 31/00; G01R 31/396;
H01M 10/48; H02J 7/00

(22) Date of filing: 20.10.2023

(86) International application number:
PCT/JP2023/038034

(87) International publication number:
WO 2024/106137 (23.05.2024 Gazette 2024/21)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 15.11.2022 JP 2022182741

(71) Applicant: Panasonic Energy Co., Ltd.
Osaka 570-8511 (JP)

(72) Inventors:
• SUYAMA Atsushi
 Kadoma-shi, Osaka 571-0057 (JP)
• MAEGAWA Kazuya
 Kadoma-shi, Osaka 571-0057 (JP)

(74) Representative: Novagraaf International SA
Chemin de l'Echo 3
1213 Onex, Geneva (CH)

(54) **BATTERY PACK, TEMPERATURE MEASUREMENT CIRCUIT, AND METHOD FOR DIAGNOSING FAILURE IN BATTERY PACK**

(57) Even abnormality in components of the temperature measurement circuit such as the reference resistor or reference voltage can be determined. The battery pack is provided with a first temperature sensor; a first voltage divider resistor; a first switch unit that is OFF under normal conditions and turned ON during failure diagnosis; a first reference resistor with one terminal grounded and the other terminal connected to the first switch unit; and a controller connected to a first connection node, capable of detecting voltage at the first connection node, and capable of controlling the ON/OFF state of the first switch unit. The controller computes an ideal voltage at the first connection node during failure diagnosis based on normal voltage at the first connection node when the first switch unit is OFF, compares actual voltage measured at the first connection node during failure diagnosis with the first switch unit ON to the ideal voltage, and determines failure when the difference between actual voltage and ideal voltage exceeds a predetermined first range.

FIG. 1

EP 4 621 422 A1

# EP 4 621 422 A1

**Description**

TECHNICAL FIELD

The present disclosure relates to a battery pack, temperature measurement circuit, and method for diagnosing battery pack failure.

BACKGROUND ART

Battery pack power source apparatus that employ batteries that can be recharged such as lithium-ion rechargeable batteries are used to supply power to electrical equipment including vehicles such as electric scooters, cordless electric tools, and portable electronic devices. Since rechargeable battery cells generate heat during charging and discharging, battery cell temperature is monitored to ensure operation within a normal temperature range. Safety measures, such as limiting charge/discharge current or cutting off current when necessary, are implemented based on the temperature measurements. Accordingly, power source apparatus are provided with temperature measurement circuitry equipped with temperature sensors, such as thermistors, to monitor rechargeable battery cell temperature.

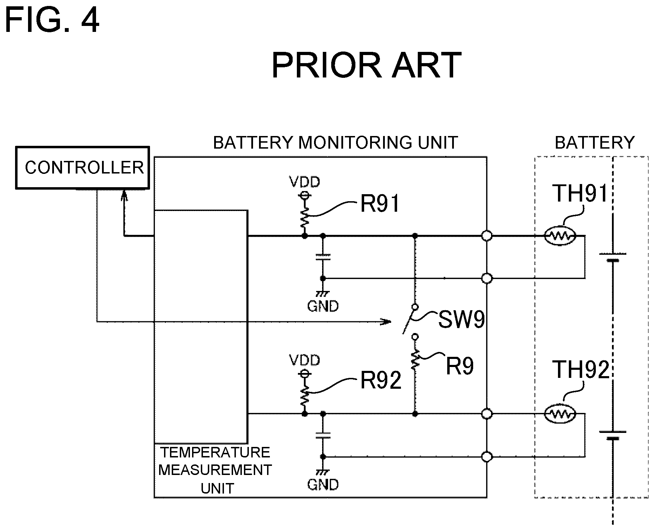

In recent years, functional safety standards have been established to ensure safety, and in particular systems that can detect failures are in demand. For example, Patent Literature 1 discloses a battery temperature monitoring device that can detect short circuit across the terminals of a plurality of thermistors corresponding to each rechargeable battery cell. As shown in FIG. 4, this battery temperature monitoring device establishes conduction between a plurality of temperature measurement systems through a switch element SW9, and detects short circuits by comparing temperature measurement system voltages before and after switching SW9 from OFF to ON. If no voltage change is detected, short circuit is concluded in the plurality of temperature sensors TH91 and TH92. Conversely, if voltage change is detected, no failure due to short circuit in temperature sensors TH91 and TH92 is concluded.

However, while this method can detect short circuit failure within the thermistors, it is unable to detect failure in components other than the thermistors. The possibility of failure is not limited to the thermistors, and failure can also occur in power supply circuitry and resistors used for temperature measurement. In FIG. 4, even if the temperature sensors TH91 and TH92 are functioning normally, the temperature monitoring system can malfunction due to power supply circuit failure that causes change in the supply voltage VDD, or due to resistor R91, R92, R9 shift or failure. As a result, failure diagnosis does not function appropriately when the temperature sensors TH91 and TH92 fail to detect the correct temperature.

CITATION LIST

PATENT LITERATURE

Patent Literature 1: Japanese Laid-Open Patent Publication 2020-123433

SUMMARY OF THE INVENTION

TECHNICAL PROBLEM

One object of the present disclosure is to provide a battery pack, temperature measurement circuit, and method for diagnosing battery pack failure that can diagnose failure even when malfunction occurs in components that make up the temperature measurement circuit such as reference resistors and reference voltage sources.

SOLUTION TO PROBLEM

The battery pack for one embodiment of the present disclosure comprises a plurality of rechargeable battery cells; a first temperature sensor that has one terminal grounded and the other terminal connected to a first connection node P1, is thermally coupled to a first rechargeable battery cell, which is one of the plurality of rechargeable battery cells, and can measure first temperature information related to first rechargeable battery cell temperature; a first voltage divider resistor with one terminal connected to the first connection node P1 and the other terminal connected to a first reference voltage source; a first switch unit which has one terminal connected to the first connection node P1 and the other terminal connected to a first reference resistor described next, and which is OFF under normal conditions and turned ON during failure diagnosis; a first reference resistor with one terminal grounded and the other terminal connected to the first switch unit; a controller connected to the first connection node P1, capable of detecting voltage at the first connection node P1, and capable of controlling the ON/OFF state of the first switch unit; and is configured such that the controller computes an ideal voltage at the first connection node P1 for failure diagnosis based on normal voltage at the first connection node P1 measured when the first switch unit is OFF, compares the ideal voltage with actual voltage at the first connection node P1 during failure diagnosis measured when the first switch unit is ON, and determines failure when the difference between the actual and ideal voltages exceeds a predetermined first range.

ADVANTAGEOUS EFFECTS OF THE INVENTION

With the battery pack for one embodiment of the present disclosure, not only can first temperature sensor failure be detected, but also any abnormality in components such as the first reference resistor or the first reference voltage source can also be detected. This realizes the feature that reliability of the first battery temperature measurement system is improved.

BRIEF DESCRIPTION OF THE DRAWINGS

FIG. 1 is a circuit diagram showing a battery pack for one embodiment of the present disclosure.
FIG. 2 is a graph showing an example of the relation between voltage across the thermistor Vm1 and battery temperature.
FIG. 3 is a flowchart illustrating one example of the procedure for diagnosing battery pack failure.
FIG. 4 is a circuit diagram showing a prior art battery temperature monitoring device.

DESCRIPTION OF EMBODIMENTS

Other embodiments of the present invention may be identified by the following configurations and features.
A battery pack according to another embodiment of the present invention is configured by that, as recited in any of forgoing embodiments, the controller turns the first switch unit ON with predetermined timing to connect the first reference resistor to the controller through the first connection node P1 to implement failure diagnosis of the first battery temperature measurement system. This configuration enables periodic failure diagnosis of the first battery temperature measurement system to enhance reliability.
A battery pack according to another embodiment of the present invention is configured by that, as recited in any of forgoing embodiments, predetermined timing for failure diagnosis is coincident with battery pack connection to a battery charger for charging.
A battery pack according to another embodiment of the present invention is configured by that, as recited in any of forgoing embodiments, the time point for measuring the normal voltage at the first connection node P1 with the first switch unit OFF, and the time point for measuring the actual voltage at the first connection node P1 during failure diagnosis with the first switch unit ON are within one second. This configuration makes the time point where normal voltage at the first connection node P1 Vm1 is measured to compute ideal voltage at the first connection node P1 for failure diagnosis close to the time point where actual voltage at the first connection node P1 during failure diagnosis is measured. This minimizes first temperature sensor error in rechargeable battery cell temperature due to time difference in the measurements.
Further, a battery pack according to another embodiment of the present invention is configured by that, as recited in any of forgoing embodiments, the controller is provided with a memory unit that pre-stores the relation between voltage across the first temperature sensor and temperature.
Still further, a battery pack according to another embodiment of the present invention is configured by that, the ideal voltage at the first connection node P1 for failure diagnosis is evaluated by computing Equation 1, 2, and 3 as follows.
[Equation 1]
The resistance of the first temperature sensor during normal operation is given by the equation:

$$Rth1 = Rdiv1 \times Vm1 / (Vcc - Vm1)$$

[Equation 2]

The composite resistance (during failure diagnosis) of the parallel connected Rref1 and Rth1 is given by the equation:

$$Rmix1 = Rref1 \times Rth1 / (Rref1 + Rth1)$$

[Equation 3]

The ideal voltage at the first connection node P1 during failure diagnosis is given by the equation:

$$Vc1 = Vcc \times Rmix1 / (Rdiv1 + Rmix1)$$

Parameters in the above equations and related values are as follows.

Rref1: resistance of the first reference resistor
Rdiv1: resistance of the first voltage divider resistor
Vcc: voltage of the reference voltage source
Vm1: voltage at the first connection node P1 during normal operation
Tm1: temperature of the first rechargeable battery cell during normal operation
Vd1: actual measured voltage at the first connection node P1 during failure diagnosis
Vc1: ideal voltage at the first connection node P1 during failure diagnosis

Still further, a battery pack according to another embodiment of the present invention is configured by that, the first temperature sensor is a thermistor, and the first temperature information is the electrical resistance of the thermistor.

Still further, a battery pack according to another embodiment of the present invention is configured by that, it further comprises a second temperature sensor that has one terminal grounded and the other terminal connected to a second connection node, is thermally coupled to a second rechargeable battery cell, which is one of the plurality of battery cells different than the first rechargeable battery cell, and can measure second temperature information related to second rechargeable battery cell temperature; a second voltage divider resistor with one terminal connected to the second connection node and the other terminal connected to a second reference voltage source; a second switch unit which has one terminal connected to the second connection node and the other terminal connected to a second reference resistor described next, and which is OFF under normal conditions and turned ON during failure diagnosis; a second reference resistor with one terminal grounded and the other terminal connected to the second switch unit; the previously described controller is connected to the second connection node, is capable of detecting voltage at the second connection node, is capable of controlling the ON/OFF state of the second switch unit, and is configured such that after measuring actual voltage at the first connection node P1 during failure diagnosis and judging whether or not failure has occurred, the controller computes an ideal voltage at the second connection node for failure diagnosis based on normal voltage at the second connection node measured with the first switch unit and the second switch unit in the OFF state, compares the ideal voltage with actual voltage at the second connection node during failure diagnosis measured when the second switch unit is ON, and determines failure when the difference between the actual and ideal voltages exceeds a predetermined second range. This configuration realizes the feature that even when a plurality of temperature sensors is provided for a plurality of battery cells, which of the rechargeable battery temperature measurement systems is abnormal can be identified by failure diagnosis that switches through the plurality of battery cells.

Still further, a battery pack according to another embodiment of the present invention is configured by that the voltage of the first reference voltage source and the second reference voltage source are equal.

Still further, a battery pack according to another embodiment of the present invention is configured by that the resistance of the first voltage divider resistor is equal to the resistance of the second voltage divider resistor, and the resistance of the first reference resistor is equal to the resistance of the second reference resistor.

Still further, a battery pack according to another embodiment of the present invention is configured by that the first rechargeable battery cell and the second rechargeable battery cell have the same characteristics, and the first temperature sensor and the second temperature sensor also have the same characteristics.

Still further, a battery pack according to another embodiment of the present invention is configured by that the predetermined first range and the predetermined second range are equal.

Still further, a temperature measurement circuit according to another embodiment of the present invention is configured by that is a temperature measurement circuit that detects temperature of an electronic circuit heat-generating component, and is provided with a temperature sensor that has one terminal grounded and the other terminal connected to a connection node, is thermally coupled to the heat-generating component, and can measure temperature information related to the temperature of the heat-generating component; a voltage divider resistor, which has one terminal connected to the connection node and the other terminal connected to a reference voltage source; a switch unit which has one terminal connected to the connection node and the other terminal connected to the reference resistor described below, and which is OFF under normal conditions and turned ON during failure diagnosis; a reference resistor with one terminal grounded and the other terminal connected to the switch unit; a controller connected to the connection node, capable of detecting voltage at the connection node, and capable of controlling the ON/OFF state of the switch unit; and is configured such that the controller computes an ideal voltage at the connection node during failure diagnosis based on the normal voltage at the connection node measured with the switch unit in the OFF state, compares the ideal voltage with actual voltage at the connection node during failure diagnosis measured with the switch unit in the ON state, and determines failure when the difference between the actual and ideal voltages exceeds a predetermined range.

Still further, a method for diagnosing battery pack failure according to another embodiment of the present invention is configured by that is a method for diagnosing failure of a battery pack provided with a plurality of rechargeable battery cells; a first temperature sensor that has one terminal grounded and the other terminal connected to a first connection node P1, is thermally coupled to a first rechargeable battery cell, which is one of the plurality of rechargeable battery cells, and capable of measuring first temperature information related to the first battery temperature; a first voltage divider resistor, which has one terminal connected to a first connection node P1 and the other terminal connected to a first reference voltage source; a controller connected to the first connection node P1, and capable of detecting voltage at the first connection node P1; and the method includes a step for the controller to measure normal voltage at the first connection node P1 with a first switch unit, which has one terminal connected to the first connection node P1 and the other terminal connected to a first reference resistor, in the OFF state, and compute ideal voltage at the first connection node P1 during failure diagnosis based on the measured normal voltage; and a step for the controller to switch the first switch unit to the ON state, measure actual voltage at the first connection node P1 during failure diagnosis, compare the actual voltage with the ideal voltage at the first connection node P1 during failure diagnosis, and determine failure if the difference exceeds a predetermined first range.

Still further, a method for diagnosing battery pack failure according to another embodiment of the present invention is configured by that the ideal voltage at the first connection node P1 during failure diagnosis is computed using the following Equation 1, 2, and 3.

[Equation 1]

The resistance of the first temperature sensor during normal operation is given by the equation:

$$Rth1 = Rdiv1 \times Vm1 / (Vcc - Vm1)$$

[Equation 2]

The composite resistance (during failure diagnosis) of the parallel connected first reference resistor Rref1 and the first temperature sensor Rth1 is given by the equation:

$$Rmix1 = Rref1 \times Rth1 / (Rref1 + Rth1)$$

[Equation 3]

The ideal voltage at the first connection node P1 during failure diagnosis is given by the equation:

$$Vc1 = Vcc \times Rmix1 / (Rdiv1 + Rmix1)$$

Parameters in the above equations and related values are as follows.

Rref1: resistance of the first reference resistor
Rdiv1: resistance of the first voltage divider resistor
Vcc: voltage of the reference voltage source
Vm1: voltage at the first connection node P1 during normal operation
Tm1: temperature of the first rechargeable battery cell during normal operation
Vd1: actual measured voltage at the first connection node P1 during failure diagnosis
Vc1: ideal voltage at the first connection node P1 during failure diagnosis

Still further, a method for diagnosing battery pack failure according to another embodiment of the present invention is configured by that it includes an additional step where the controller switches the first switch unit OFF after the step that judges temperature measurement system failure with the first switch unit ON; a second temperature sensor with one terminal grounded and the other terminal connected to a second connection node is in contact with a second rechargeable battery cell different from the first rechargeable battery cell and is capable of measuring second temperature information related to the second battery temperature, the terminal of the second temperature sensor connected to the second connection node is also connected to one terminal of a second voltage divider resistor and the other terminal of the second voltage divider resistor is connected to a second reference voltage source, one terminal of a second reference resistor is grounded and the other terminal is connected to a second switch unit; the method further includes a step where the controller switches the second switch unit to the OFF state, measures normal voltage at the second connection node, and computes ideal voltage at the second connection node during failure diagnosis based on the measured normal voltage; and a step where the controller switches the second switch unit ON, measures actual voltage at the second connection node during failure diagnosis, compares the actual voltage with the ideal voltage at the second connection node during failure diagnosis, and determine failure if the difference exceeds a predetermined second range. Accordingly, even when a plurality of temperature sensors is provided for a plurality of battery cells, not only can malfunction in any of the temperature sensors, such as the second temperature sensor, be detected, but also abnormality in the components of each battery temperature measurement system, such as the second reference resistor or the second reference voltage source can also be detected by the controller to achieve the benefit of improved reliability.

The following describes embodiments of the present invention with reference to the drawings. However, embodiments described below are examples of the technical concept of the present invention and are not intended to limit the scope of the invention to those examples. Further, components described in the claims are not limited to components in the embodiments. In particular, unless specifically stated otherwise, dimensions, materials, shapes, relative disposition, and other details of the components described below are merely illustrative and are not intended to limit the scope of the invention. Note that the size, positional relationships, and other characteristics of components shown in the drawings may be exaggerated for the purpose of clear explanation. In addition, identical names and reference numbers in the following descriptions indicate identical or similar components, and their detailed explanations may be omitted as appropriate. Elements of the present invention may be configured such that a plurality of elements combine to form a single component that serves a plurality of functions, and conversely, a plurality of elements can implement a single function.

The battery pack of the present invention can be used as the driving power source in vehicles such as delivery robots, electric golf carts, electric scooters, construction machinery, and hybrid vehicles and electric automobiles. It can also serve as the driving power source in electric-assist bicycles. Further it can function as the power source in portable electric devices such as wireless communication devices, electric cleaners, and electric power tools. Alternatively, it can be used as a stationary power storage device such as the backup power supply for a computer server, or as an electric power source in the household, office, or factory. The following describes an example of a battery pack that supplies power to a portable electric device.

[Embodiment 1]

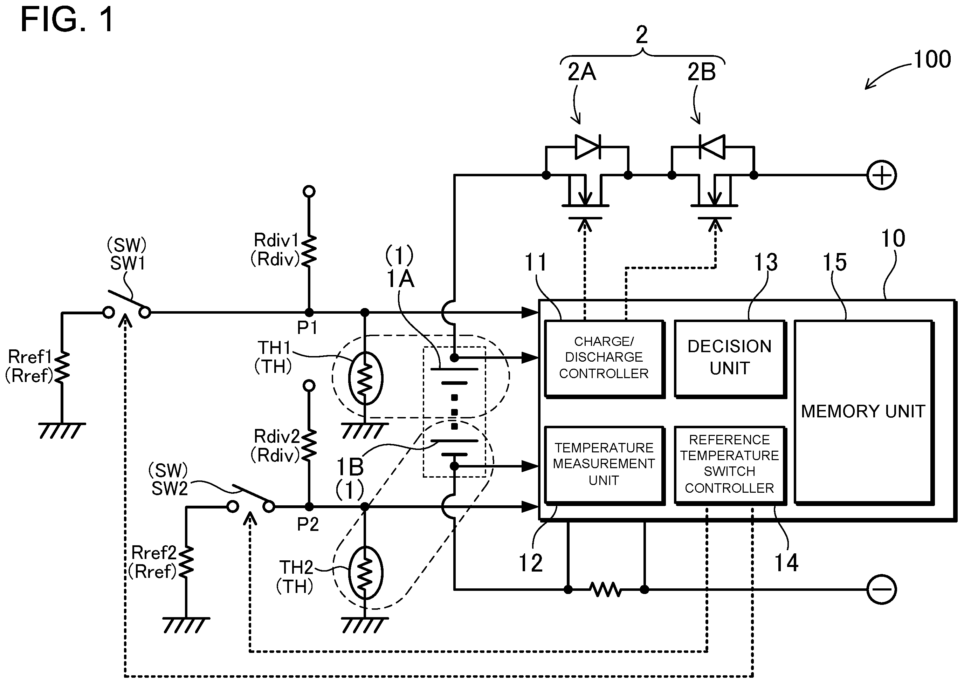

FIG. 1 shows a battery pack 100 for Embodiment 1 of the present invention. The battery pack 100 in the figure is provided with a plurality of rechargeable battery cells 1, a charge/discharge switch 2 for charging and discharging the rechargeable battery cells 1, a temperature sensor TH, a reference resistor Rref, a voltage divider resistor Rdiv, a switch unit SW, and a controller 10. The temperature sensor TH, reference resistor Rref, voltage divider resistor Rdiv, switch unit SW, and controller 10 form a temperature measurement circuit that measures the temperature of the rechargeable battery cells 1. The temperature measurement circuit measures rechargeable battery cell 1 temperature. If the temperature of a rechargeable battery cell 1 exceeds a preset range, malfunction is assumed, and safety measures, which include turning OFF the charge/discharge switch 2 to suspend charging and discharging, are implemented.

A plurality of temperature sensors TH, reference resistors Rref, and switch units SW can be provided. In particular, when a battery block with a plurality of rechargeable battery cells 1 connected in series or parallel is used it is desirable to detect the temperature of each individual rechargeable battery cell. Accordingly, the number of temperature sensors TH provided is equal to the number of rechargeable battery cells 1 for which temperature detection is desired, and a corresponding reference resistor Rref, voltage divider resistor Rdiv, and switch unit SW are provided for each temperature sensor TH. In the example shown in FIG. 1, temperature sensors TH are a first temperature sensor TH1 and a second temperature sensor TH2, reference resistors Rref are a first reference resistor Rref1 and a second reference resistor Rref2, voltage divider resistors Rdiv are a first voltage divider resistor Rdiv1 and a second voltage divider resistor Rdiv2, and switch units SW are a first switch unit SW1 and a second switch unit SW2. The number of temperature sensors TH, reference resistors Rref, voltage divider resistors Rdiv, and switch units SW are not limited to two each, and three or more can be provided as well. Here, the first temperature measurement circuit, which detects first battery temperature for the first rechargeable battery cell 1A, is made up of the first temperature sensor TH1, the first reference resistor Rref1, the first voltage divider resistor Rdiv1, the first switch unit SW1, and is referred to as the first battery temperature measurement system. Similarly, the second battery temperature measurement circuit, which detects second battery temperature for the second rechargeable battery cell 1B is made up of the second temperature sensor TH2, the second reference resistor Rref2, the second voltage divider resistor Rdiv2, the second switch unit SW2, and is referred to as the second battery temperature measurement system.

In the example shown in FIG. 1, rechargeable battery cells 1 are connected in series. However, the present disclosure is not limited to this configuration and parallel connection or a combination of series and parallel connections are also possible. Due to illustration constraints, FIG. 1 shows the first temperature sensor TH1 and the second temperature sensor TH2 separated from their respective rechargeable battery cells 1. However, in practice each temperature sensor is disposed in intimate contact with the exterior case of each respective rechargeable battery cell 1.

(Rechargeable Battery Cells 1)

One or more rechargeable battery cells 1, which have a cylindrical, rectangular or polygonal prism, or pouch-type (laminated cell) exterior case, can be used. As previously described, the number and arrangement of rechargeable battery cells, as well as the number of series or parallel connections, can be adopted as appropriate. Each rechargeable battery cell 1 has a positive and negative electrode. Presently known rechargeable batteries such as lithium-ion rechargeable batteries, nickel-metal hydride rechargeable batteries, and nickel-cadmium rechargeable batteries can be appropriately used as the rechargeable battery cells 1.

(Temperature Sensor TH)

Temperature sensors TH are thermally coupled to rechargeable battery cells selected for temperature detection. The temperature sensor TH acquires temperature data corresponding to the temperature of the rechargeable battery cell that it is thermally coupled with. Here, the first temperature sensor TH1 detects first temperature information corresponding to the first battery temperature of the first rechargeable battery cell 1A, and the second temperature sensor TH2 detects second temperature information corresponding to the second battery temperature of the second rechargeable battery cell 1B. The first and second temperature sensors TH1 and TH2 are disposed in intimate contact with the exterior cases of their respective rechargeable battery cells 1. To thermally couple each temperature sensor TH with its respective rechargeable battery cell 1, the sensor can be attached to the surface of the cell's exterior case with glue, or potted in contact with the exterior case in the gap between adjacent cells.

In the example shown in FIG. 1, the first temperature sensor TH1 has one terminal grounded and the other terminal electrically connected to a first connection node P1. Similarly, the second temperature sensor TH2 has one terminal grounded and the other terminal electrically connected to a second connection node P2.

(Voltage Divider Resistor Rdiv)

The first voltage divider resistor Rdiv1 has one terminal connected to the first connection node P1 and the other terminal connected to the first reference voltage source Vcc1. Similarly, the second voltage divider resistor Rdiv2 has one terminal connected to the second connection node P2 and the other terminal connected to the second reference voltage source Vcc2. Preferably, resistance of the first voltage divider resistor Rdiv1 and the second voltage divider resistor Rdiv2 are equal. The resistance of each voltage divider resistor Rdiv can be, for example, several tens of kΩ.

(Reference Resistor Rref)

The first reference resistor Rref1 has one terminal grounded and the other terminal connected to the first switch unit SW1. Similarly, the second reference resistor Rref2 has one terminal grounded and the other terminal connected to the second switch unit SW2. Preferably, resistance of the first reference resistor Rref1 and the second reference resistor Rref2 are equal. The resistance of each reference resistor Rref can be, for example, several tens of kΩ. Preferably, reference resistor Rref resistance the is on the same order as the voltage divider resistor Rdiv resistance.

(Reference Voltage Source)

The first reference voltage source Vcc1 is an externally driven power source that powers electronic components such as the controller 10, and is connected to the terminal of the first voltage divider resistor Rdiv1 that is not connected to the first connection node P1. Similarly, the second reference voltage source Vcc2 is connected to the terminal of the second voltage divider resistor Rdiv2 that is not connected to the second connection node P2. The first reference voltage source Vcc1 and the second reference voltage source Vcc2 can be separate voltage sources, but preferably they share a common reference voltage Vcc, such as +3.3V or +5V.

(Switch Unit SW)

The first switch unit SW1 has one terminal connected to the first connection node P1 and the other terminal connected to the first reference resistor Rref1. Similarly, the second switch unit SW2 has one terminal connected to the second connection node P2 and the other terminal connected to the second reference resistor Rref2. ON/OFF states of the switch units SW1 and SW2 are controlled individually by the controller 10. Each switch unit SW is normally in the OFF state and is turned ON during failure diagnosis. Specifically, for diagnosing failure of the first battery temperature measurement system, the first switch unit SW1 is turned ON, while other switches, such as the second switch unit SW2 in the example of FIG. 1, are turned OFF. For diagnosing failure of the second battery temperature measurement system, the second switch unit SW2 is turned ON, while the other switches, such as the first switch unit SW1, are turned OFF. Preferably, semiconductor switching devices such as MOSFETs or bipolar transistors are used as the switch units SW.

(Charge/Discharge Switch 2)

The charge/discharge switches 2 are switches for charging and discharging the rechargeable battery cells 1 that make up the battery block. Semiconductor power devices such as power FETs can be appropriately used as charge/-discharge switches 2. Here, a charging FET is used as a charging switch 2A and a discharging FET used as a discharging switch 2B. The charging FET and discharging FET are connected in series to form the charge/discharge switches 2.

(Controller 10)

The controller 10 is connected to the first connection node P1 and the second connection node P2, making it possible to detect voltages at those nodes. The controller 10 also controls ON/OFF states of the first switch unit SW1 and the second switch unit SW2. The controller 10 can be implemented via a microcontroller or ASIC (Application Specific Integrated Circuit).

In the example shown in FIG. 1, controller 10 functional elements include a charge/discharge controller 11, a temperature measurement unit 12, a decision unit 13, a reference temperature switch controller 14, and a memory unit 15. The charge/discharge controller 11 controls the ON/OFF states of the charge/discharge switches 2. The temperature measurement unit 12 performs A/D conversion of voltages at the first connection node P1 and the second connection node P2, and computes first battery temperature from first temperature data and second battery temperatures from second temperature data. The decision unit 13 diagnoses failure of each battery temperature measurement system as described subsequently. The reference temperature switch controller 14 controls ON/OFF states of the first switch unit SW1 and the second switch unit SW2. The memory unit 15 stores the relationship between temperature sensor TH measured voltages acquired by the temperature measurement unit 12 and the battery temperature. The memory unit 15 can be implemented with non-volatile memory such as EEPROM (Electronically Erasable Programmable Read-Only Memory).

With the first switch unit SW1 in the OFF state, the controller 10 measures normal voltage Vm1 at the first connection node P1, and based on that measured voltage, the decision unit 13 computes ideal voltage Vc1 for failure diagnosis at the first connection node P1. For diagnosing failure, the reference temperature switch controller 14 turns the first switch unit SW1 ON with the second switch unit SW2 in the OFF state, and the temperature measurement unit 12 measures actual voltage Vd1 at the first connection node P1 during failure diagnosis. The actual voltage Vd1 at the first connection node P1 during failure diagnosis is compared with the previously calculated ideal voltage Vc1 for failure diagnosis at the first connection node P1, and the decision unit 13 determines whether or not the difference between actual and ideal voltages exceeds a predefined first voltage range Vdiff1. If the difference exceeds the first voltage range, failure is concluded; if the difference is within the first voltage range, normal operation is assumed. Note that while prior art systems can diagnose temperature sensor failure, diagnosis is problematic when components other than the temperature sensors fail. However, the controller 10 in the battery pack 100 of this embodiment can detect abnormality in components that make up the first battery temperature measurement system, such as the first voltage divider resistor Rdiv1, the first reference resistor Rref1, and the first reference voltage source. This realizes the feature that battery temperature measurement system reliability is improved.

First battery temperature measurement system failure can be diagnosed as described above. Similarly, second battery temperature measurement system failure can be diagnosed as described below. Namely, the battery pack 100 of this embodiment can not only determine whether or not failure has occurred, it can also identify which of the plurality of battery temperature measurement systems has failed. Failure diagnosis of the second battery temperature measurement system is performed as follows. Timed not to conflict with failure diagnosis of the first battery temperature measurement system, for example, after or before first system diagnosis, the reference temperature switch controller 14 in the controller 10 switches both the first switch unit SW1 and the second switch unit SW2 OFF. The temperature measurement unit 12 measures normal voltage at the second connection node P2 and ideal voltage Vc2 for failure diagnosis at the second connection node P2 is computed based on the measured normal voltage Vm2 at the second connection node P2. Next, with the first switch unit SW1 in the OFF state and the second switch unit SW2 switched from OFF to ON, the decision unit 13 measures actual voltage Vd2 at the second connection node P2 during failure diagnosis. The actual voltage Vd2 at the second connection node P2 during failure diagnosis is compared with the ideal voltage Vc2 and failure is determined if the difference exceeds a predefined second voltage range Vdiff2. This enables the controller 10 to detect abnormalities not only in each temperature sensor TH (in this case, in the second temperature sensor TH2) but also in components that make up the second battery temperature measurement system including the second voltage divider resistor Rdiv2, the second reference resistor Rref2, and the second reference voltage source This can improve reliability. Here, the first voltage range Vdiff1 and the second voltage range Vdiff2 may have different values but preferably they are set to the same voltage range Vdiff.

(Temperature Data)

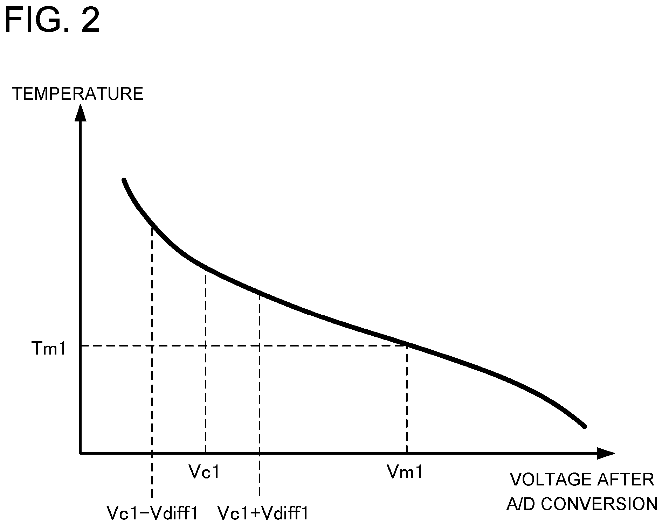

The first temperature sensor TH1 and the second temperature sensor TH2, which are the temperature sensors TH, can be thermistors or thermocouples. In the example of FIG. 1, NTC (Negative Temperature Coefficient) thermistors are used as the temperature sensors TH. In this case, temperature information (data) acquired by the temperature sensor TH corresponds to the electrical resistance of the thermistor. Resistance of an NTC thermistor decreases as temperature increases, and battery temperature can be detected by measuring the voltage across the thermistor. For example, detection of the first battery temperature of the first rechargeable battery cell 1A utilizes the relationship between the voltage Vm1 across the first temperature sensor and battery temperature. The voltage Vm1 across the first temperature sensor is detected by the controller 10 as the voltage at the first connection node P1. For example, as shown in the graph in FIG. 2, there is a set relation between voltage Vm1 across the first temperature sensor and first battery temperature. By predetermining the voltage-temperature relation for the first temperature sensor and storing that relationship in the memory unit 15, first battery temperature can be detected by measuring voltage Vm1 across the first temperature sensor. Here, normal first battery temperature is designated Tm1, and first battery temperature during failure diagnosis is designated Td1. Note that if the first rechargeable battery cell 1A and the second rechargeable battery cell 1B are the same type of rechargeable battery cell 1 with similar characteristics, and if the first temperature sensor TH1 and the second temperature sensor TH2 have the same characteristics, such as thermistors with the same part number, and further if the resistance of the first reference resistor Rref1 and the second reference resistor Rref2, the resistance of the first voltage divider resistor Rdiv1 and the second voltage divider resistor Rdiv2, and the voltage of the first reference voltage source Vcc1 and the second reference voltage source Vcc2 are all equal, the relation between first temperature sensor voltage Vm1 and first battery temperature is also valid for use as the relation between second temperature sensor voltage Vm2 and second battery temperature.

(Operation)

To measure temperature of the rechargeable battery cells 1 in the battery pack 100 shown in FIG. 1, the first temperature sensor TH1 is disposed next to the first rechargeable battery cell 1A and the second temperature sensor TH2 is disposed next to the second rechargeable battery cell 1B. The first voltage divider resistor Rdiv1 is connected in series with the first temperature sensor TH1 between the reference voltage source Vcc and ground (GND), and the second voltage divider resistor Rdiv2 and the second temperature sensor TH2 also have the same series-connected configuration between Vcc and ground (GND).

The resistance of the first temperature sensor TH1, which is an NTC thermistor, decreases as temperature increases. The temperature measurement unit 12 can detect temperature by reading the voltage Vm1 (voltage across the temperature sensor), which is the reference voltage Vcc voltage-divided by the series-connected first voltage divider resistor Rdiv1 and the resistance Rth1 of the first temperature sensor TH1 (which varies with temperature). Accordingly, the memory unit 15 stores a table, graph, or approximation curve that indicates the relation between voltage Vm1 across the temperature sensor and the battery temperature.

The graph of FIG. 2 shows an example of the relation between voltage Vm1 across the first temperature sensor and battery temperature. The relation between temperature sensor voltage and battery temperature shown in this figure is stored in the memory unit 15 as a table or parameters of an approximation curve. Consequently, battery temperature Tm1 can be determined at the time Vm1 is detected by referencing the memory unit 15. Battery temperature for other temperature measurement systems, such as the system that includes the second temperature sensor TH2, can be detected similarly.

(Method of Diagnosing Temperature Measurement System Failure)

The following describes the method of diagnosing failure of the temperature measurement system. The reference temperature switch controller 14 turns the first switch unit SW1 ON at a predetermined time. For example, the predetermined time can be before or after the start of battery pack 100 charging or discharging, such as when the battery pack 100 is connected to a charger. When the first switch unit SW1 is turned ON periodically at the predetermined times, the temperature measurement unit 12 in the controller 10 detects the voltage Vd1 across the temperature sensor (during failure diagnosis). Here, the following Equation 1, 2, and 3 are computed as follows.

[Equation 1]

The resistance Rth1 of the first temperature sensor TH1 when Vm1 (voltage during normal operation) is detected is given by the equation:

$$Rth1 = Rdiv1 \times Vm1 / (Vcc - Vm1)$$

[Equation 2]

The composite resistance Rmix1 (during failure diagnosis) of the parallel connected Rref1 and Rth1 is given by the equation:

$$Rmix1 = Rref1 \times Rth1 / (Rref1 + Rth1)$$

[Equation 3]

The ideal voltage Vc1 at the first connection node P1 during failure diagnosis (voltage across a properly operating temperature sensor) is given by the equation:

$$Vc1 = Vcc \times Rmix1 / (Rdiv1 + Rmix1)$$

Parameters in the above equations and related values are as follows.

Rref1: resistance of the first reference resistor
Rdiv1: resistance of the first voltage divider resistor
Vcc: voltage of the reference voltage source
Vm1: voltage at the first connection node P1 (across the first temperature sensor) during normal operation
Tm1: temperature of the first rechargeable battery cell 1A during normal operation
Vd1: actual measured voltage at the first connection node P1 (voltage across the first temperature sensor) during failure diagnosis
Vc1: ideal voltage Vc1 at the first connection node P1 during failure diagnosis

Using the equations above, voltage across the temperature sensor during failure diagnosis Vd1 can be acquired. Namely, Vd1 is the voltage across the composite resistance Rmix1 (resistance of the parallel connected Rref1 and Rth1 obtained from the equation 2), which along with the first voltage divider resistor Rdiv1, voltage divides the reference voltage source Vcc. Here, since the voltage of the reference voltage source Vcc, the resistance of the first voltage divider resistor Rdiv1, and the resistance of the first reference resistor Rref1 are known, ideal voltage Vc1 across the temperature sensor during failure diagnosis can be calculated by the Equation 3.

If the first temperature sensor TH1 is functioning normally, the voltage read during failure diagnosis is approximately equal to the ideal voltage Vd1 ≈ Vc1. However, if the reference voltage or resistance values change significantly, for example, due to reference voltage source Vcc or first voltage divider resistor Rdiv1 malfunction, the value of Vd1 will deviate from Vc1. If a constant Vdiff1 is defined to account for deviation from the ideal value, abnormality is concluded if Vd1 > Vc1 + Vdiff1 or if Vd1 < Vc1 - Vdiff1, and continued use of a battery pack that measures battery temperature abnormally can be prevented. The threshold value Vdiff1 or failure determination can be appropriately selected considering tolerance values for components such as the reference voltage source Vcc and the first voltage divider resistor Rdiv1.

The predetermined range ±Vdiff can be set individually for each temperature sensor, but preferably a common value is used for all temperature sensors. For example, ±Vdiff1 can be used for the first temperature sensor TH1 and ±Vdiff2 can be used for the second temperature sensor TH2, allowing different values to be assigned based on the characteristics of each temperature sensor. In particular, if temperature sensor type or manufacturer differs, individual settings are preferable. However, ideally temperature sensors with identical characteristics are used and the predetermined range as ±Vdiff is standardized to simplify processing.

[Method of Diagnosing Battery Pack Failure]

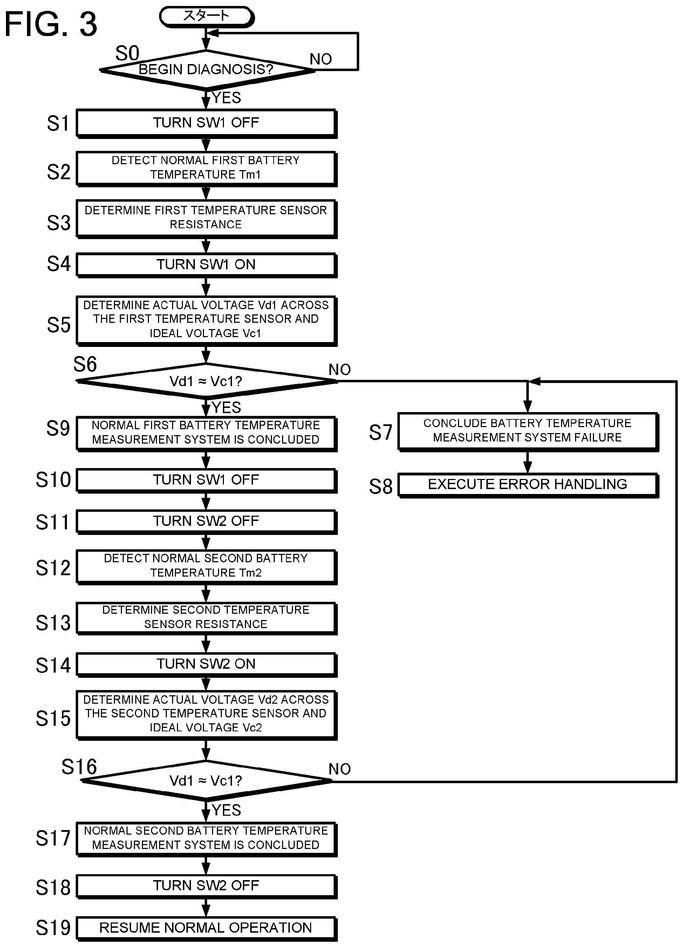

Here, an explicit procedure for diagnosing failure in a battery pack that uses the temperature measurement circuit is described based on the flowchart in FIG. 3. First, in step S0, the decision to initiate failure diagnosis is made. For example, the controller 10 determines whether or not preset timing for executing failure diagnosis is appropriate. For instance, this can include verifying the periodic interval of a timer circuit, and/or determining whether or not the battery pack is connected to a charger or to the electrical device that is powered by the battery pack.

(Battery Temperature Tm1 Measurement)

When the decision to initiate failure diagnosis is made, the first switch unit SW1 is turned OFF in step S1. Next, normal first battery temperature Tm1 is detected in step S2. Here, first temperature sensor voltage Vm1 is acquired and converted into normal first battery temperature Tm1 using the relationship shown in FIG. 2. In step S3, the resistance Rth1 of the first temperature sensor TH1 at the time of Vm1 measurement is calculated using the equation 1. Measurement error due to battery temperature variation during failure diagnosis can be reduced by measuring first battery temperature Tm1 immediately prior to entering the failure diagnosis mode. This makes it possible to ignore battery temperature variation during the short time interval $\Delta t$ for failure diagnosis. Preferably, the time point for normal voltage measurement at the first connection node P1 with the first switch unit SW1 OFF and the time point for actual voltage measurement at the first connection node P1 during failure diagnosis with the first switch unit SW1 turned ON are within one second.

(Failure Diagnosis of the First Battery Temperature Measurement System)

Next, control transitions to the failure diagnosis mode for the first battery temperature measurement system. Specifically, in step S4, the first switch unit SW1 is turned ON. In step S5, the actual measured voltage Vd1 and the ideal voltage Vc1 across the first temperature sensor during failure diagnosis are obtained. The actual voltage across the first temperature sensor during failure diagnosis Vd1 is measured by the controller 10, while the ideal voltage across the first temperature sensor during failure diagnosis Vc1 is calculated by the controller 10. Here, the first composite resistance during failure diagnosis Rmix1 and the ideal voltage Vc1 during failure diagnosis are computed. Specifically, composite resistance during failure diagnosis Rmix1 is calculated by the equation 2 from the first reference resistance Rref1 and the resistance Rth1 of the first temperature sensor TH1. Next, ideal voltage Vc1 during failure diagnosis is calculated by the Equation 3 from the reference voltage source voltage Vcc, composite resistance during failure diagnosis Rmix1, and first voltage divider resistance Rdiv1.

In step S6, actual voltage across the first temperature sensor during failure diagnosis Vd1 and ideal voltage across the first temperature sensor during failure diagnosis Vc1 are compared to determine whether or not deviation between the two values is within the preset range. Specifically, if the preset range for the first temperature sensor TH1 is $\pm$Vdiff1, the inequalities Vd1 > Vc1 + Vdiff1 and Vd1 < Vc1 - Vdiff1 are evaluated. If either inequality is satisfied, processing proceeds to step S7, and first battery temperature measurement system failure is concluded. In step S8, prescribed error handling is executed. Error handling can include, for example, charge/discharge controller 11 suspension of charging and discharging by putting the charging FET and the discharging FET in the OFF state. Or, the controller 10 can use its communication capability to send an alarm to the device connected with the battery pack. If step S6 determines that Vd1 and Vc1 are within the preset range, processing proceeds to step S9, where normal first battery temperature measurement system is concluded.

(Failure Diagnosis of the Second Battery Temperature Measurement System)

In step S10, the first switch unit SW1 is turned OFF to complete failure diagnosis of the first battery temperature measurement system including the first temperature sensor TH1 and begin failure diagnosis of the next battery temperature measurement system. Since the example of FIG. 1 has a second battery temperature measurement system that includes the second temperature sensor TH2, failure diagnosis of that system is executed. First, in preparation for diagnosing failure of the second battery temperature measurement system, second battery temperature Tm2 is measured. Specifically, the second switch unit SW2 is turned OFF in step S11, and normal second battery temperature Tm2 is detected in step S12 (in the same manner as Tm1 detection in step S2). Here, the voltage across the second temperature sensor Vm2 is measured and converted into normal second battery temperature Tm2. In step S13, resistance Rth2 of the second temperature sensor TH2 at the time of Vm2 measurement is calculated by the equation 1. (Here, although equations 1, 2 and 3 are written for the first battery temperature measurement system, equations of the same form for resistances and voltages in the second battery temperature measurement system are also valid.)

Next, failure diagnosis of the second battery temperature measurement system is initiated. Specifically, in step S14, the second switch unit SW2 is turned ON. In step S15, the actual measured voltage across the second temperature sensor during failure diagnosis Vd2 and the ideal voltage across the second temperature sensor during failure diagnosis Vc2 are obtained. Here, in the same manner performed for the first temperature sensor, actual measured voltage Vd2 is measured by the controller 10, while the ideal voltage Vc2 is calculated by the controller 10. Namely, the second composite resistance Rmix2 and the ideal voltage across the second temperature sensor during failure diagnosis Vc2 are computed.

Second composite resistance Rmix2 is calculated by the equation 2 using the parallel connected second reference resistance Rref2 and the resistance Rth2 of the second temperature sensor TH2. Ideal voltage Vc2 is calculated by the Equation 3 using the second reference voltage source voltage Vcc, the second composite resistance Rmix2, and the second voltage divider resistance Rdiv2.

In step S16, the actual measured voltage across the second temperature sensor during failure diagnosis Vd2 and the ideal voltage Vc2 are compared to determine whether or not deviation between the two values is within the preset range. Specifically, when the preset range for the second temperature sensor TH2 is $\pm$Vdiff2, the inequalities Vd2 > Vc2 + Vdiff2 and Vd2 < Vc2 - Vdiff2 are evaluated. If either condition is satisfied, processing loops back to step S7, and failure of the battery temperature measurement system is concluded. In step S8, prescribed error handling is executed. Conversely, if step S16 determines that Vd1 and Vc1 are within the preset range, processing proceeds to step S17, where normal temperature measurement circuit operation is concluded. In step S18, the second switch unit SW2 is turned OFF to complete failure diagnosis of the second battery temperature measurement system related to the second temperature sensor TH2.

If the battery pack has additional battery (cell) temperature measurement systems, failure diagnosis transitions to the next system and application of the same procedure is continued. Here, processing can include a step to determine whether or not additional battery temperature measurement systems exist as well as steps to repeat similar failure diagnosis accordingly.

When failure diagnosis of all the battery temperature measurement systems is complete, processing proceeds to step S19 where failure diagnosis is ended and normal operation resumed.

In the example described above, the battery pack is attached to an electrical device and supplies power to that device. Accordingly, when remaining battery pack capacity diminishes, or when battery pack function degrades over time, it can be replaced to continue electrical device operation. However, the present invention is not limited to exchangeable battery packs that house rechargeable battery cells, but is also applicable to electrical equipment that houses rechargeable battery cells inside the equipment casing. In this disclosure, a "battery pack" can be any configuration that has rechargeable battery cells housed within a case, and that includes rechargeable battery cells built-in to the case of the electrical equipment that it powers. Namely, the present disclosure is not limited to exchangeable battery packs, but is also applicable to electrical equipment that has built-in rechargeable battery cells.

Further, the battery pack has temperature measurement circuitry that measures rechargeable battery cell temperature and includes a failure diagnosis function for that temperature measurement circuitry. However, the present disclosure does not limit failure diagnosis to temperature measurement circuits that measure the temperature of rechargeable battery cells within a battery pack. Failure diagnosis can also be applied to temperature measurement circuits that monitor other components in the battery pack, such as charge/discharge FETs or other integrated circuits. Further, as described above, the term "battery pack" in this disclosure also includes electrical equipment that has built-in rechargeable battery cells. Accordingly, electrical equipment powered by internal rechargeable battery cells can also include temperature measurement circuits that monitor the temperature of electronic components such as FETs or integrated circuits, as well as other structural components in the equipment. Consequently, the temperature measurement circuit disclosed here can also be applied to temperature measurement in those types of electrical devices.

INDUSTRIAL APPLICABILITY

The battery pack, temperature measurement circuit, and method for diagnosing battery pack failure disclosed here is suitable for battery packs that require functional safety compliance, such as power supplies for mobile apparatus including electric assist bicycles and electric carts. The present disclosure can also be appropriately applied in power supplies for wireless communication devices, cordless vacuum cleaners, electric hand-tools, and other portable electrical devices.

REFERENCE SIGNS LIST

| | |
|---|---|
| 100 | battery pack |
| 1 | rechargeable battery cell |
| 1A | first rechargeable battery cell |
| 1B | second rechargeable battery cell |
| 2 | charge/discharge switch |
| 2A | charging switch |
| 2B | discharging switch |
| 10 | controller |

| 11 | charge/discharge controller |
| 12 | temperature measurement unit |
| 13 | decision unit |
| 14 | reference temperature switch controller |
| 15 | memory unit |
| TH91, TH92 | temperature sensors |
| SW9 | switch |
| R91, R92, R9 | resistors |
| P1 | first connection node |
| P2 | second connection node |
| TH | temperature sensor |
| TH1 | first temperature sensor |
| TH2 | second temperature sensor |
| Rdiv | voltage divider resistor |
| Rdiv1 | first voltage divider resistor |
| Rdiv2 | second voltage divider resistor |
| Rref | reference resistor |
| Rref1 | first reference resistor |
| Rref2 | second reference resistor |
| SW | switch unit |
| SW1 | first switch unit |
| SW2 | second switch unit |

**Claims**

1. A battery pack comprising:

    a plurality of rechargeable battery cells;
    a first temperature sensor that has one terminal grounded and the other terminal connected to a first connection node, is thermally coupled to a first rechargeable battery cell, and can measure first temperature information related to first rechargeable battery cell temperature;
    a first voltage divider resistor with one terminal connected to the first connection node and the other terminal connected to a first reference voltage source;
    a first switch unit which has one terminal connected to the first connection node and the other terminal connected to a first reference resistor, and which is OFF under normal conditions and turned ON during failure diagnosis;
    the first reference resistor with one terminal grounded and the other terminal connected to the first switch unit; and
    a controller connected to the first connection node, capable of detecting voltage at the first connection node, and capable of controlling the ON/OFF state of the first switch unit,
    wherein the controller is configured to compute an ideal voltage at the first connection node for failure diagnosis based on normal voltage at the first connection node measured when the first switch unit is OFF, compare the ideal voltage with actual voltage at the first connection node during failure diagnosis measured when the first switch unit is ON, and determine failure when the difference between the actual and ideal voltages exceeds a predetermined first range.

2. The battery pack as recited in claim 1, wherein the controller is configured to turn the first switch unit ON with predetermined timing to connect the first reference resistor to the controller through the first connection node to implement failure diagnosis of the first battery temperature measurement system.

3. The battery pack as recited in claim 2, wherein the predetermined timing for failure diagnosis is coincident with battery pack connection to a battery charger for charging.

4. The battery pack as recited in claim 1, wherein the time point for controller measurement of the normal voltage at the first connection node with the first switch unit OFF, and the time point for measurement of the actual voltage at the first connection node during failure diagnosis with the first switch unit ON are within one second.

5. The battery pack as recited in claim 1, wherein the controller comprises a memory unit that pre-stores the relation between voltage across the first temperature sensor and temperature.

6. The battery pack as recited in any of the claims 1 to 5, wherein the ideal voltage at the first connection node for failure diagnosis is evaluated by computing Equation 1, 2, and 3 as follows,

Equation 1: The resistance of the first temperature sensor during normal operation is given by the equation:

$$Rth1 = Rdiv1 \times Vm1 / (Vcc - Vm1)$$

Equation 2: The composite resistance (during failure diagnosis) of the parallel connected Rref1 and Rth1 is given by the equation:

$$Rmix1 = Rref1 \times Rth1 / (Rref1 + Rth1)$$

Equation 3: The ideal voltage at the first connection node during failure diagnosis is given by the equation:

$$Vc1 = Vcc \times Rmix1 / (Rdiv1 + Rmix1)$$

and wherein,

Rref1: resistance of the first reference resistor
Rdiv1: resistance of the first voltage divider resistor
Vcc: voltage of the reference voltage source
Vm1: voltage at the first connection node during normal operation
Tm1: temperature of the first rechargeable battery cell during normal operation
Vd1: actual measured voltage at the first connection node during failure diagnosis
Vc1: ideal voltage at the first connection node during failure diagnosis

7. The battery pack as recited in any of the claims 1 to 5, wherein the first temperature sensor is a thermistor, and the first temperature information is the electrical resistance of the thermistor.

8. The battery pack as recited in claim 1, further comprising:

a second temperature sensor that has one terminal grounded and the other terminal connected to a second connection node, is thermally coupled to a second rechargeable battery cell, which is one of the plurality of battery cells different than the first rechargeable battery cell, and can measure second temperature information related to second rechargeable battery cell temperature;
a second voltage divider resistor with one terminal connected to the second connection node and the other terminal connected to a second reference voltage source;
a second switch unit which has one terminal connected to the second connection node and the other terminal connected to a second reference resistor, and which is OFF under normal conditions and turned ON during failure diagnosis; and
the second reference resistor with one terminal grounded and the other terminal connected to the second switch unit,
wherein the controller that is connected to the second connection node, is capable of detecting voltage at the second connection node, and is capable of controlling the ON/OFF state of the second switch unit; and configured such that after measuring actual voltage at the first connection node during failure diagnosis and judging whether or not failure has occurred, the controller computes an ideal voltage at the second connection node for failure diagnosis based on normal voltage at the second connection node measured with the first switch unit and the second switch unit in the OFF state, compares the ideal voltage with actual voltage at the second connection node during failure diagnosis measured when the second switch unit is ON, and determines failure when the difference between the actual voltage and ideal voltage exceeds a predetermined second range.

9. The battery pack as recited in claim 8, wherein the voltage of the first reference voltage source and the second reference voltage source are made equal.

10. The battery pack as recited in claim 8, wherein the resistance of the first voltage divider resistor is made equal to the resistance of the second voltage divider resistor, and the resistance of the first reference resistor is made equal to the resistance of the second reference resistor.

11. The battery pack as recited in claim 8, wherein the first rechargeable battery cell and the second rechargeable battery cell have the same characteristics, and the first temperature sensor and the second temperature sensor also have the same characteristics.

12. The battery pack as recited in claim 8, wherein the predetermined first range and the predetermined second range are equal.

13. A temperature measurement circuit that detects the temperature of a heat-generating component in an electronic circuit, comprising:

a temperature sensor that has one terminal grounded and the other terminal connected to a connection node, is thermally coupled to the heat-generating component, and can measure temperature information related to the temperature of the heat-generating component;
a voltage divider resistor, which has one terminal connected to the connection node and the other terminal connected to a reference voltage source;
a switch unit which has one terminal connected to the connection node and the other terminal connected to the reference resistor described below, and which is OFF under normal conditions and turned ON during failure diagnosis;
a reference resistor with one terminal grounded and the other terminal connected to the switch unit;
a controller connected to the connection node, capable of detecting voltage at the connection node, and capable of controlling the ON/OFF state of the switch unit; and
configured such that the controller computes an ideal voltage at the connection node during failure diagnosis based on the normal voltage at the connection node measured with the switch unit in the OFF state, compares the ideal voltage with actual voltage at the connection node during failure diagnosis measured with the switch unit in the ON state, and determines failure when the difference between the actual and ideal voltages exceeds a predetermined range.

14. A method for diagnosing failure of a battery pack comprising:

a plurality of rechargeable battery cells;
a first temperature sensor that has one terminal grounded and the other terminal connected to a first connection node, is thermally coupled to a first rechargeable battery cell, which is one of the plurality of rechargeable battery cells, and capable of measuring first temperature information related to the first battery temperature;
a first voltage divider resistor, which has one terminal connected to a first connection node and the other terminal connected to a first reference voltage source;
a controller connected to the first connection node, and capable of detecting voltage at the first connection node;
wherein the method comprises:

a step for the controller to measure normal voltage at the first connection node with a first switch unit, which has one terminal connected to the first connection node and the other terminal connected to a first reference resistor, in the OFF state, and compute ideal voltage at the first connection node during failure diagnosis based on the measured normal voltage; and
a step for the controller to switch the first switch unit to the ON state, measure actual voltage at the first connection node during failure diagnosis, compare the actual voltage with the ideal voltage at the first connection node during failure diagnosis, and determine failure if the difference exceeds a predetermined first range.

15. The method for diagnosing failure of a battery pack as recited in claim 14, wherein the ideal voltage at the first connection node for failure diagnosis is evaluated by computing Equation 1, 2, and 3 as follows:

Equation 1: the resistance of the first temperature sensor during normal operation is given by the equation:

$$Rth1 = Rdiv1 \times Vm1 / (Vcc - Vm1)$$

Equation 2: the composite resistance (during failure diagnosis) of the parallel connected Rref1 and Rth1 is given by the equation:

$$Rmix1 = Rref1 \times Rth1 / (Rref1 + Rth1)$$

Equation 3: the ideal voltage at the first connection node during failure diagnosis is given by the equation:

$$Vc1 = Vcc \times Rmix1 / (Rdiv1 + Rmix1)$$

wherein:

Rref1: resistance of the first reference resistor
Rdiv1: resistance of the first voltage divider resistor
Vcc: voltage of the reference voltage source
Vm1: voltage at the first connection node during normal operation
Tm1: temperature of the first rechargeable battery cell during normal operation
Vd1: actual measured voltage at the first connection node during failure diagnosis
Vc1: ideal voltage at the first connection node during failure diagnosis

**16.** The method for diagnosing failure of a battery pack as recited in claim 14, further comprising:

a step in which the controller switches the first switch unit OFF after the step that judges temperature measurement system failure with the first switch unit ON;
wherein the battery pack is configured such that a second temperature sensor with one terminal grounded and the other terminal connected to a second connection node is in contact with a second rechargeable battery cell different from the first rechargeable battery cell and is capable of measuring second temperature information related to the second battery temperature, the terminal of the second temperature sensor connected to the second connection node is also connected to one terminal of a second voltage divider resistor and the other terminal of the second voltage divider resistor is connected to a second reference voltage source, one terminal of a second reference resistor is grounded and the other terminal is connected to a second switch unit, which has its other terminal connected to the second connection node;
the method further includes a step in which the controller switches the second switch unit to the OFF state, measures normal voltage at the second connection node, and computes ideal voltage at the second connection node during failure diagnosis based on the measured normal voltage; and
a step in which the controller switches the second switch unit ON, measures actual voltage at the second connection node during failure diagnosis, compares the actual voltage with the ideal voltage at the second connection node during failure diagnosis, and determine failure if the difference exceeds a predetermined second range.

FIG. 1

# FIG. 2

TEMPERATURE

Tm1

Vc1

Vm1

Vc1−Vdiff1    Vc1+Vdiff1

VOLTAGE AFTER
A/D CONVERSION

# FIG. 3

スタート

**S0** BEGIN DIAGNOSIS? — NO

↓ YES

**S1** TURN SW1 OFF

**S2** DETECT NORMAL FIRST BATTERY TEMPERATURE Tm1

**S3** DETERMINE FIRST TEMPERATURE SENSOR RESISTANCE

**S4** TURN SW1 ON

**S5** DETERMINE ACTUAL VOLTAGE Vd1 ACROSS THE FIRST TEMPERATURE SENSOR AND IDEAL VOLTAGE Vc1

**S6** Vd1 ≈ Vc1? — NO

↓ YES

**S9** NORMAL FIRST BATTERY TEMPERATURE MEASUREMENT SYSTEM IS CONCLUDED

**S10** TURN SW1 OFF

**S11** TURN SW2 OFF

**S12** DETECT NORMAL SECOND BATTERY TEMPERATURE Tm2

**S13** DETERMINE SECOND TEMPERATURE SENSOR RESISTANCE

**S14** TURN SW2 ON

**S15** DETERMINE ACTUAL VOLTAGE Vd2 ACROSS THE SECOND TEMPERATURE SENSOR AND IDEAL VOLTAGE Vc2

**S16** Vd1 ≈ Vc1? — NO

↓ YES

**S17** NORMAL SECOND BATTERY TEMPERATURE MEASUREMENT SYSTEM IS CONCLUDED

**S18** TURN SW2 OFF

**S19** RESUME NORMAL OPERATION

**S7** CONCLUDE BATTERY TEMPERATURE MEASUREMENT SYSTEM FAILURE

**S8** EXECUTE ERROR HANDLING

# FIG. 4

## PRIOR ART

BATTERY MONITORING UNIT                    BATTERY

CONTROLLER

VDD
R91
GND

TH91

SW9

R9

VDD
R92
GND

TH92

TEMPERATURE
MEASUREMENT
UNIT

## INTERNATIONAL SEARCH REPORT

| International application No. |
| --- |
| **PCT/JP2023/038034** |

### A. CLASSIFICATION OF SUBJECT MATTER

*G01R 31/00*(2006.01)i; *G01K 1/14*(2021.01)i; *G01K 7/24*(2006.01)i; *G01R 31/396*(2019.01)i; *H01M 10/48*(2006.01)i; *H02J 7/00*(2006.01)i
FI:    G01R31/00; G01K1/14 L; G01K7/24 M; G01R31/396; H01M10/48 P; H01M10/48 301; H02J7/00 Q

According to International Patent Classification (IPC) or to both national classification and IPC

### B. FIELDS SEARCHED

Minimum documentation searched (classification system followed by classification symbols)

G01R31/00; G01K1/14; G01K7/24; G01R31/396; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2004-157024 A (OMRON CORPORATION) 03 June 2004 (2004-06-03) entire text, all drawings | 1-16 |
| A | JP 7-333074 A (NITTAN CO LTD) 22 December 1995 (1995-12-22) entire text, all drawings | 1-16 |
| A | JP 2009-250613 A (NISSAN MOTOR CO LTD) 29 October 2009 (2009-10-29) entire text, all drawings | 1-16 |
| A | WO 2017/150013 A1 (SANYO ELECTRIC CO., LTD.) 08 September 2017 (2017-09-08) entire text, all drawings | 1-16 |
| A | KR 10-2019-0129573 A (LG CHEM, LTD.) 20 November 2019 (2019-11-20) entire text, all drawings | 1-16 |
| A | JP 2009-264779 A (PANASONIC CORP) 12 November 2009 (2009-11-12) entire text, all drawings | 1-16 |

☑ Further documents are listed in the continuation of Box C.     ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **13 December 2023** | **26 December 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2023/038034** |

## C. DOCUMENTS CONSIDERED TO BE RELEVANT

| Category* | Citation of document, with indication, where appropriate, of the relevant passages | Relevant to claim No. |
| --- | --- | --- |
| A | KR 10-2020-0086471 A (LG CHEM, LTD.) 17 July 2020 (2020-07-17) entire text, all drawings | 1-16 |

Form PCT/ISA/210 (second sheet) (January 2015)

**INTERNATIONAL SEARCH REPORT**
Information on patent family members

International application No.

**PCT/JP2023/038034**

| Patent document cited in search report | | | Publication date (day/month/year) | Patent family member(s) | | | Publication date (day/month/year) |
|---|---|---|---|---|---|---|---|
| JP | 2004-157024 | A | 03 June 2004 | US 2004/0114667 A1 entire text, all drawings EP 1418412 A1 | | | |
| JP | 7-333074 | A | 22 December 1995 | (Family: none) | | | |
| JP | 2009-250613 | A | 29 October 2009 | (Family: none) | | | |
| WO | 2017/150013 | A1 | 08 September 2017 | JP 17-150013 A1 US 2019/0051952 A1 entire text, all drawings CN 108700475 A | | | |
| KR | 10-2019-0129573 | A | 20 November 2019 | (Family: none) | | | |
| JP | 2009-264779 | A | 12 November 2009 | (Family: none) | | | |
| KR | 10-2020-0086471 | A | 17 July 2020 | (Family: none) | | | |

Form PCT/ISA/210 (patent family annex) (January 2015)

**EP 4 621 422 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020123433 A